# EUROPEAN PATENT SPECIFICATION

(11) **EP 0 476 687 B1**
(45) Date of publication and mention of the grant of the patent: **15.03.2000**
(21) Application number: 91116036.4
(22) Date of filing: 20.09.1991
(51) Int. Cl.: H01L 39/22, H01L 39/24

(54) **Superconductor junction structure and process for fabricating the same**
Supraleiterübergangsstruktur und Verfahren zu deren Herstellung
Structure d'adjonction supraconducteur et procédé pour sa fabrication

(30) Priority: 20.09.1990 JP 25162090
(43) Date of publication of application: 25.03.1992
(73) Proprietor: SUMITOMO ELECTRIC INDUSTRIES, LIMITED, Osaka 541 (JP)
(72) Inventor: Tanaka, Saburo, c/o Itami Works, Itami-shi, Hyogo (JP); Matsuura, Takashi, c/o Itami Works, Itami-shi, Hyogo (JP); Itozaki, Hideo, c/o Itami Works, Itami-shi, Hyogo (JP)
(74) Representative: Lehn, Werner, Dipl.-Ing.

(56) References cited:
- EP-A- 0 017 389
- EP-A- 0 458 013
- JP-A- 1 035 972
- JP-A- 1 117 376
- JP-A- 2 084 781
- JP-A- 63 306 676
- US-A- 5 034 374
- PATENT ABSTRACTS OF JAPAN vol. 13, no. 103 (E-725) 10 March 1989 & JP-A-63 276 284 ( NIPPON TELEGRAPH )
- PATENT ABSTRACTS OF JAPAN vol. 13, no. 166 (E-746) 20 April 1989 & JP-A-63 318 176 ( NIPPON TELEGRAPH )
- SOLID STATE TECHNOLOGY vol. 33, no. 5, May 1990, TULSA, US pages 255 - 260; Koch R.H. et al: 'SQUIDS made from High Temperature Superconductors'
- IBM TECHNICAL DISCLOSURE BULLETIN vol. 31, no. 9, February 1989, NEW YORK, US page 217; 'High Tc superconducting oxide sandwich structures and tunnel junctions'
- PATENT ABSTRACTS OF JAPAN vol. 14, no. 268 (E-939)[4211] 11 June 1990 & JP-A-02 084 781 (FUJITSU LTD)
- PATENT ABSTRACTS OF JAPAN vol. 13, no. 186 (E-752)[3534] 02 May 1989 & JP-A-01 012 585 (MITSUBISHI ELECTRIC CORP.) 17 January 1989
- PATENT ABSTRACTS OF JAPAN vol. 13, no. 356 (E-803) 09 August 1989 & JP-A-01 117 376 (MITSUBISHI ELECTRIC CORP) 10 May 1989
- PATENT ABSTRACTS OF JAPAN vol. 13, no. 232 (E-765) 29 May 1989 & JP-A-01 039 084 (MITSUBISHI ELECTRIC CORP.) 09 February 1989
- PATENT ABSTRACTS OF JAPAN vol. 13, no. 226 (E-763) 25 May 1989 & JP-A-01 035 971 (MITSHUBISHI ELECTRIC CORP) 07 February 1989
- JAPANESE JOURNAL OF APPLIED PHYSICS, vol. 29, December 1990, pages L2199-L2202

## Description

### Detailed Description of the Invention

### (Field of the Invention)

The present invention relates to a superconductor junction structure. Specifically the present invention relates to a new superconductor junction structure using an oxide superconductor.

### (Related Background Art)

There are various structures for realizing superconductor junctions, which are represented by Josephson junction, and the most preferable structure is the tunnel junction comprising a thin non-superconductor (which does not have superconductive characteristics) sandwiched by a pair of superconductors. Generally these superconductor junctions have very fine structures, and these superconductors and the non-superconductors are formed of the so-called films. For example, in realizing a tunnel junction by using an oxide superconducting material as the superconductors, a first oxide superconducting film, a non-superconducting film, and a second oxide superconducting film are laminated in the stated order. The non-superconductor, an insulator, e.g., MgO or others. a semiconductor, e.g., Si or others, or a metal, e.g., Au or others, may be used as the non-superconductor and they are selected, depending on applications. Tunnel type superconductor junctions having such structures have different properties from one another depending on the selected material. On the other hand, a superconductor junction structure, which does not have non-superconducting layer interposed in the barrier portion of a tunnel, is disclosed in Appl. Phys. Lett., 56(7), 12 February 1990, p.686-688 published by R.B. Laibowitz et al. The oxide superconductor used in this superconductor junction structure disclosed therein is Y-B-C-O group.

JP-A-63 276 284 describes a high-temperature superconductor junction structure having superconducting layers of (La_{0.9}Ba_{0.1})₂CuO₄ and a tunnel barrier of an oxide of Cu, Mo or V formed in a step. The superconducting layers are formed by rf magnetron sputtering in Ar gas and the tunnel barrier is formed by dc magnetron sputtering. A La₂ CuO₄ polycrystalline insulating substrate is used.

JP-A-2 084 781 describes a high-temperature superconductor junction structure formed from dissimilar ceramic superconducting materials and a hetero-junction section formed by mutual diffusion on junction surfaces in a process in which the hetero-junction is shaped. Examples of the ceramic superconducting materials used are Y-Ba-Cu-O group materials and Bi-Sr-Ca-Cu-O group materials. Examples of substrates used are MgO and SrTiO₃. The hetero-junction structure may be formed into a step.

JP-A-63 318 186 describes a superconductor junction structure having two superconducting layers arranged in a step separated by a tunnel barrier and a buffer layer formed from a very thin (e.g. 3nm) precious metal film to produce a tunnel type Josephson junction device. The buffer layer may be constituted from Au, Pt, Pd, Ag or an alloy thereof.

JP-A-1 012 585 describes a superconductor junction structure having superconducting layers of Ba₂YCu₃O₇ with an orthorhombic crystal structure and a barrier layer of Ba-Y-Cu-O group material with a tetragonal crystal structure.

JP-A-1 117 376 describes a superconductor junction structure having two superconducting layers of La-Sr-Cu-O arranged in a step. The two superconducting layers are separated by a thin insulating film on the side face of the step formed by doping one of the superconducting layers with impurity ions and an insulating film of SiO₂ on the top face of the step.

JP-A-1 039 084 describes a planar superconductor junction structure formed on a substrate of SrTiO₃ and having two superconducting layers of Y-Ba-Cu-O with c-crystallographic axis aligned parallel to the substrate surface.

JP-A-1 035 971 describes a superconductor junction structure having two superconducting layers and an insulating layer arranged in a step on a perovskite type oxide insulator substrate. One of the superconducting layers of a perovskite type oxide superconductor is grown on the substrate with c-crystallographic axis aligned perpendicular to the substrate surface.

US-A-5 034 374 describes a method of producing a high temperature superconductor Josephson junction comprising the steps of: forming a lower ceramic superconductor film on a substrate; forming an upper ceramic superconductor of a different system ceramic from the lower ceramic superconductor film on a portion of the lower ceramic superconductor and on the substrate; and forming an insulating layer (tunnel barrier) between the lower and upper ceramic superconductor films by inter diffusion therebetween. The lower ceramic superconductor film may have a composition of Y-Ba-Cu-O and the upper ceramic superconductor film may have a composition of Bi-Sr-Ca-Cu-O.

JP-A-62 191 697 describes a superconductor junction device employing a perovskite type oxide superconductor including a trivalent rare earth element as the superconductor layer and a perovskite type oxide insulator including a rare earth element except for trivalent ones as the tunnel insulating layer. Since the various layers are different in the types of rare earth elements used but employ elements with similar properties, the various layers have similar crystal structure.

JP-A-62 142 631 describes a Josephson junction element formed from a junction layer between electrodes of a metal oxide superconductor, the junction layer being made of a metal oxide having a different composition ratio from that of the metal oxide superconductor.

"Crystal Orientation of YBa₂Cu₃O_{7-y} Thin Films Prepared by RF Sputtering" by T. Arikawa *et al*., Japanese Journal of Applied Physics, Volume 29, No. 12, December 1990, ppL 2199 to L 2202 describes the dependence of Cu/Y and Ba/Y atomic ratios on the substrate temperature when forming a thin film oxide superconductor by sputtering.

The thickness of the non-superconductor of a tunnel type superconductor junction is determined by a coherence length of the superconductor. The oxide superconductors have very short coherence lengths, and therefore the tunnel type superconductor junctions using oxide superconductors must have the non-superconductors of which thickness is about some nanometers.

On the other hand, in view of the operational properties of the superconductor junctions, the respective layers must be single crystals, or polycrystals having orientation very similar to single crystals.

In the above-described tunnel type superconductor junction, a first oxide superconducting film a non-superconducting film and a second oxide superconducting film, each of which has good crystallinity, must be laminated.

It is difficult to form an oxide superconducting film having good crystallinity on an oxide superconducting film, and it is very difficult to form an oxide superconducting film having good crystallinity further on the non-superconducting film due to properties of the oxide superconductor. Conventionally, even if the above formed structure should have been realized, the desired good properties cannot be obtained due to unsatisfactory conditions of the interface between the oxide superconductor and the non-superconductor.

### Summary of the Invention

It is one object of the present invention to provide a superconductor junction structure and a process for producing the same which use an oxide superconductor and have a new constitution, and which can successfully solve the above-described conventional problems.

Accordingly, in one aspect, the present invention provides a superconductor junction structure comprising a first superconductive layer of an oxide superconductor material formed in a desired pattern on a substrate such that the first superconductive layer has a top face and a plurality of side faces; a non-superconductive layer of a non-superconductive material formed from a first portion on the top face and a second portion on at least a part of the side faces of the first superconductive layer, such that the second portion of the non-superconductive layer is thinner than the first portion and forms a tunnel barrier at said at least one part of the side faces of the first superconductive layer; and a second superconductive layer of said oxide superconductor material formed on the first and second portions of the non-superconductive layer and on the surface of the substrate; wherein the non-superconductive layer is also formed from a third portion on a part of the surface of the substrate adjoining said at least one part of the side faces of the first superconductive layer and extending in a first direction along the surface of the substrate, the thickness of the second portion of the non-superconductive layer being less than a length of said third portion extending in said first direction, said first, second and third portions of said non-superconductive layer all being of said non-superconductor material; and wherein the second superconductive layer is also formed on said third portion of the non-superconductive layer.

In another aspect, the present invention provides a method of making a superconductor junction structure comprising: depositing a first superconductive layer of an oxide superconductor material in a desired pattern on a substrate, such that the first superconductive layer has a top face and a plurality of side faces; depositing a non-superconductive layer of a non-superconductive material in a first portion on the top face and in a second portion on at least a part of the side faces of the first superconductive layer such that the second portion of the non-superconductive layer is thinner than the first portion and forms a tunnel barrier at said at least one part of the side faces of the first superconductive layer; and depositing a second superconductive layer of said oxide superconductor material on the first and second portions of the non-superconductive layer and on the surface of the substrate; further comprising depositing the non-superconductive layer in a third portion on a part of the surface of the substrate adjoining said at least one part of the side faces of the first superconductive layer and extending in a first direction along the surface of the substrate such that the thickness of the second portion of the non-superconductive layer is less than the length of said third portion extending in said first direction, said first, second and third portions of said non-superconductive layer all being of said non-superconductive material; and depositing said second superconductive layer on said third portion of the non-superconductive layer.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter.

### Brief Description of the Drawings

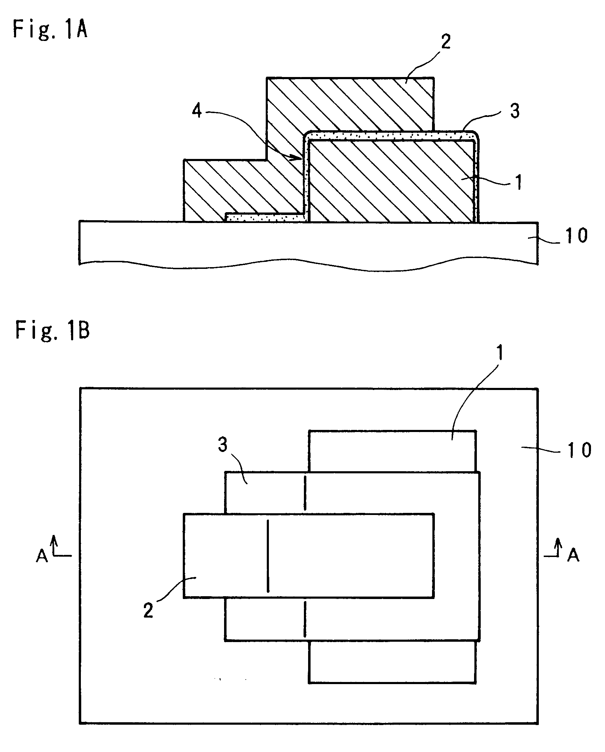

FIGs. 1A and B are views of the superconductor junction structure according to one embodiment of this invention, FIG. 1A being a sectional view of the plan view of FIG. 1B along the line A-A.

### Description of the Preferred Embodiment

The superconductor junction structure according to the present invention has a first superconducting layer of an oxide superconductor, and a second superconducting layer of the oxide superconductor which is formed on the first superconducting layer in a T shape with respect to the first superconducting layer through a non-superconducting layer which is an insulator, and has one tunnel barrier between the first and second superconducting layers. In the superconductor junction structure one superconductor junction is formed per one second superconducting layer For example, when two second superconducting layers are arranged parallel with each other, two superconductor junctions are formed.

The superconductor junction according to the present invention as claimed is tunnel-type junction. In the present invention, the superconductor junction is not realized only by simple direct lamination of the superconducting layer, the non-superconducting layer and the superconducting layer among them. The superconductor junction as claimed is formed by the portions of the non-superconducting layer laminated on the first superconducting layer which are adjacent to the side faces of the first superconducting layer, and the portion of the second superconducting layer laminated on the non-superconducting layer which are juxtaposed with the side faces of the first superconducting layer. That is, the superconductor junction is formed in a direction parallel with the surface of the substrate.

To this end, in the superconductor junction structure according to the present invention as claimed, it is preferable to use a c-crystallographic axis oriented film of an oxide superconductor. This is the reason why the critical current density and the coherence length are high in a direction perpendicular to the c-crystallographic axis of the oxide superconductor. When the superconductor junction structure according to the present invention as claimed is formed of a c-crystallographic axis oriented oxide superconductor, its superconductor junction is formed in a direction perpendicular to the c-crystallographic axis, and has more superior properties.

The superconductor junction structure according to the invention as claimed, as described above, is not a structure in which the first superconducting layer, non-superconducting layer and the second superconducting layer are directly laminated on one another, and accordingly it is not necessary to make the non-superconducting layer to be sandwitched between the first and second superconducting layers ultra-thin. The non-superconducting layer may have an arbitrary thickness as long as the non-superconducting layer is not too thick at the portions thereof adjacent to the rising portion from an edge of the first superconducting layer, that is, side face thereof, and the second superconducting layer laminated on the non-superconducting layer can be juxtaposed with the side faces of the first superconducting layer through the non-superconducting layer interposed therebetween. The non-superconducting layer may be formed by any optional process, such as spattering, vacuum evaporation, MBE, or laser beam abrasion, and especially preferably the non-superconducting layer is formed by feeding material particles (molecules and gases) from a direction perpendicular to the surface of the substrate and depositing it on the surface of the substrate. This is the reason why the thus-fed material particles can be deposited thick on the top face of the first superconducting layer which is parallel with the surface of the substrate and thin on the side faces of the first superconducting layer which is perpendicular to the surface of the substrate.

In the superconductor junction structure according to the present invention as claimed, the respective layers have parts grown from the surface of the substrate. Consequently it is easy to epitaxially grow the non-superconducting layer on the first superconducting layer, and also the second superconducting layer on the non-superconducting layer. The layers of the resultant superconductor junction structure can have good crystallization.

In the superconductor junction structure according to the present invention as claimed, even if a plurality of the second superconducting layers are provided, these second superconducting layers are formed simultaneously so that all the superconductor junctions are formed simultaneously on the same conditions. Accordingly it is possible that the resultant superconductor junctions can have all of the superconducting properties.

In the superconductor junction structure according to the invention, the substrate can use an oxide substrate, as of MgO, SrTiO₃ or others, and the superconducting layers can use an oxide superconductor, such as a Y-Ba-Cu-O group oxide superconductor, a Bi-Sr-Ca-Cu-O group oxide superconductor, a Ti-Ba-Ca-Cu-O group oxide superconductor or others. It is preferable to use an insulator, such as MgO or others, as the non-superconducting layer.

The present invention as claimed will be explained below in more detail referring to an embodiment.

FIGs. 1A and 1B schematically show one example of the superconductor junction structure according to one embodiment of the present invention as claimed. FIG. 1A is a sectional view thereof, and FIG. 1B is a plan view thereof. The superconductor junction structure according to the present invention as claimed comprises a first superconducting layer formed in a strip shape on a substrate, and a non-superconducting layer 3 formed thick at the portion thereof on the top surface of the first superconducting layer 1 and thin on the portions thereof on the edges, that is side faces, of the first superconducting layer, and a second superconducting layer formed on the non-superconducting layer to form a T shape with respect to the first superconducting layer. A tunnel type superconductor junction is formed at a portion 4 defined by the rising edges, that is the side faces, of the superconducting layer 1, the rising edges, that is side faces, of the non-superconducting layer 3, and the rising edges, that is the side faces of the second superconducting layer 2.

In this superconductor junction structure, the first superconducting layer 1 has a thickness of, e.g., 300 nm, the non-superconducting layer 2 has a thickness of, e.g., 10 nm at the portion parallel with the surface of the substrate and, e.g., 5 nm at the portion vertical to the surface of the substrate, and the second superconducting layer 2 has a thickness of, e.g., 200 nm.

### Example 1

The superconduction junction structure of FIGs. 1A and 1B was fabricated using Y₁Ba₂Cu₃O₇₋ₓ oxide superconductor as the oxide superconductor, and MgO as the non-superconductor. The substrate 10 was provided by a MgO (100).

Firstly, the first superconducting layer 1 was formed on the substrate 10 by spattering, using a mask of Si plate with an aperture, an a sintered body containing Y, Ba and Cu in an atomic ratio of 1:2:4.5 as the target. The aperture of the mask, that is; the plane shape of the first superconducting layer 1, had a dimension of 2 mm x 50 µm, and the first superconducting layer has a thickness of 300 nm. The first superconducting layer 1 was grown on conditions which allowed the layer 1 to have the c-crystallographic axis. The spattering conditions were as follows.

| | | |
|---|---|---|
| Substrate temperature | | 630 °C |
| Spattering gas | Ar | 133 standard mm³s⁻¹ (8 standard cubic centimetres per minute; SCCM) |
| | O₂ | 66.7 standard mm³s⁻¹ (4 standard cubic centimetres per minute; SCCM) |
| Pressure | | 6.7 Pa (5 x 10⁻² Torr) |

Next the non-superconducting layer 3 was formed on the thus-formed first superconducting layer 1 using a mask, and MgO as the target, by spattering.

The plane shape of the non-superconducting layer 3 had a dimension of 1 mm x 50 µm and a thickness of 10 nm. The spattering conditions were as follows.

| | | |
|---|---|---|
| Substrate temperature | | 400 °C |
| Spattering gas | Ar | 133 standard mm³s⁻¹ (8 standard cubic centimetres per minute; SCCM) |
| | O₂ | 66.7 standard mm³s⁻¹ (4 standard cubic centimetres per minute; SCCM) |
| Pressure | | 6.7 Pa (5 x 10⁻² Torr) |

Finally the second superconducting layer 2 was formed on the same conditions as the first superconducting layer 1. But the mask of Si plate was turned by 90°, and the spattering position was moved so that the second superconducting layer 2 was formed in a T shape with respect to the first superconducting layer 1. The second superconducting layer 2 had a thickness of 200 nm.

The thus-fabricated superconductor junction according to the present invention had the first and the second superconducting layers 1, 2 formed of c-crystallographic axis oriented Y₁Ba₂Cu₃O₇₋ₓ superconductor, and the non-superconducting layer 3 formed of epitaxially grown MgO.

Thus-fabricated superconductor junction according to the present invention was made into a device to measure its properties. The device was cooled down at 85 K and was supplied with a 10 GHz frequency and an 0.1 mW-output microwave. Shapiro steps were observed at voltage points of multiples of 20.7 µV, and it was confirmed that a Josephson junction was realized.

### Example 2

The superconductor junction structure of FIG. 1 was fabricated using Bi₂Sr₂Ca₂Cu₃Oₓ oxide superconductor as the oxide superconductor, and MgO as the non-superconductor. The substrate 10 was provided by a MgO (100).

Firstly, the first superconducting layer 1 was formed on the substrate 10 by spattering, using a mask of Si plate, and a sintered body containing Bi, Sr, Ca and Cu in an atomic ratio of 2:2:2:3 as the target. The plane shape of the first superconducting layer 1 had a dimension of 2 mm x 50 µm, and a thickness of 300 nm. The first superconducting layer 1 was grown on conditions which allowed the layer 1 to have the c-crystallographic axis orientation. The spattering conditions were as follows.

| | | |
|---|---|---|
| Substrate temperature | | 650 °C |
| Spattering gas | Ar | 133 standard mm³s⁻¹ (8 standard cubic centimetres per minute; SCCM) |
| | O₂ | 66.7 standard mm³s⁻¹ (4 standard cubic centimetres per minute; SCCM) |
| Pressure | | 6.7 Pa (5 x 10⁻² Torr) |

Next the non-superconducting layer 3 was formed on the thus-formed first superconducting layer 1 by spattering, using another mask, and MgO as the target.

The plane shape of the non superconducting layer 3 had a dimension of 1 mm x 50 µm, and a thickness of 10 nm. The spattering conditions were as follows.

| | | |
|---|---|---|
| Substrate temperature | | 400 °C |
| Spattering gas | Ar | 133 standard mm³s⁻¹ (8 standard cubic centimetres per minute; SCCM) |
| | O₂ | 66.7 standard mm³s⁻¹ (4 standard cubic centimetres per minute; SCCM) |
| Pressure | | 6.7 Pa (5 x 10⁻² Torr) |

Finally the second superconducting layer 2 was formed on the same conditions as the first superconducting layer 1. But the mask of Si plate was turned by 90°, and the spattering position was moved so that the second superconducting layer 2 is formed in a T shape with respect to the first superconducting layer 1. The second superconducting layer 2 had a thickness of 200 nm.

The thus-formed superconductor junction structure according to the present invention as claimed had the first and the second superconducting layers 1, 2 formed of c-crystallographic axis oriented Bi₂Sr₂Ca₂Cu₃Oₓ superconductor, and the non-superconducting layer 3 formed of epitaxially grown MgO.

Thus-prepared superconductor junction according to the present invention as claimed was made into a device to measure its properties. The device was cooled down at 85 K and was supplied with a 10 GHz frequency and an 0.1 mW-output microwave. Shapiro steps were observed at voltage points of multiples of 41.3 µV, and it was confirmed that a Josephson junction was realized.

As described above, according to the present invention as claimed, a new tunnel type superconductor junction structure can be formed of an oxide superconductor. The superconductor junction structure according to the present invention as claimed can be easily formed without directly laminating the superconducting layers and the non-superconducting layer. Consequently the resultant superconductor junction structure can easily have good properties.

The present invention as claimed accelerates the superconductor technology to electronic devices.

From the invention as claimed thus described, it will be obvious that the invention as claimed may be varied in many ways.

## Claims

1. A superconductor junction structure comprising:
a first superconductive layer (1) of an oxide superconductor material formed in a desired pattern on a substrate (10) such that the first superconductive layer (1) has a top face and a plurality of side faces;
a non-superconductive layer (3, 4) of a non-superconductive material formed from a first portion (3) on the top face and a second portion (4) on at least a part of the side faces of the first superconductive layer (1), such that the second portion (4) of the non-superconductive layer (3, 4) is thinner than the first portion and forms a tunnel barrier at said at least one part of the side faces of the first superconductive layer (1); and
a second superconductive layer (2) of said oxide superconductor material formed on the first and second portions of the non-superconductive layer (3, 4) and on the surface of the substrate;
characterized in that:
the non-superconductive layer (3, 4) is also formed from a third portion on a part of the surface of the substrate (10) adjoining said at least one part of the side faces of the first superconductive layer (1) and extending in a first direction along the surface of the substrate, the thickness of the second portion of the non-superconductive layer being less than a length of said third portion extending in said first direction, said first, second and third portions of said non-superconductive layer all being of said non-superconductor material; and that
the second superconductive layer (2) is also formed on said third portion of the non-superconductive layer.

2. A superconductor junction structure according to Claim 1, wherein the first superconductive layer (1) is formed in a strip-shape, and
the second superconductive layer (2) is formed in a strip-shape which forms a substantial T-shape with respect to the first superconductive layer (1).

3. A superconductor junction structure according to Claim 1, wherein the first and the second superconductive layers (1, 2) are formed of a crystal with c-crystallographic axis oriented perpendicular to the surface of the substrate (10).

4. A superconductor junction structure according to Claim 1, wherein the substrate (10) is made of a metal oxide.

5. A superconductor junction structure according to Claim 1, wherein the first and second conductive layers (1, 2) are formed of a Cu-O group material, a Bi-Sr-Ca-Cu-O group material, or a Tl-Ba-Ca-Cu-O group material.

6. A superconductor junction structure according to Claim 1, wherein the non-superconductive layer (3) is made of a metal, a semiconductor or an insulator.

7. A method of making a superconductor junction structure comprising:
depositing a first superconductive layer (1) of an oxide superconductor material in a desired pattern on a substrate (10), such that the first superconductive layer (1) has a top face and a plurality of side faces;
depositing a non-superconductive layer (3, 4) of a non-superconductive material in a first portion (3) on the top face and in a second portion (4) on at least a part of the side faces of the first superconductive layer (1) such that the second portion (4) of the non-superconductive layer is thinner than the first portion and forms a tunnel barrier at said at least one part of the side faces of the first superconductive layer (1); and
depositing a second superconductive layer (2) of said oxide superconductor material on the first and second portions of the non-superconductive layer (3, 4) and on the surface of the substrate;
characterized by:
depositing the non-superconductive layer (3, 4) in a third portion on a part of the surface of the substrate (10) adjoining said at least one part of the side faces of the first superconductive layer (1) and extending in a first direction along the surface of the substrate such that the thickness of the second portion of the non-superconductive layer is less than the length of said third portion extending in said first direction, said first, second, and third portions of said non-superconductive layer all being of said non-superconductor material; and
depositing said second superconductive layer (2) on said third portion of the non-superconductive layer.

8. A method of making a superconductor junction structure according to Claim 7, wherein the first superconductive layer (1) of said oxide superconductor material is deposited with a mask with an aperture corresponding to said desired pattern positioned above the substrate (10).

9. A method of making a superconductor junction structure according to Claim 7, wherein the first and the second superconductive layers (1, 2), and the non-superconductive layer (3) are formed by sputtering, epitaxial growth, vacuum evaporation or laser beam ablasion.

## Patentansprüche

1. Supraleiterübergangsstruktur, umfassend:
eine erste supraleitende Schicht (1) eines Oxidsupraleitermaterials, welche gebildet ist in einem gewünschten Muster auf einem Substrat (10), so daß die erste supraleitende Schicht (1) eine obere Fläche und eine Vielzahl von Seitenflächen hat;
eine nicht-supraleitende Schicht (3, 4) aus einem nichtsupraleitenden Material, welche gebildet ist von einem ersten Abschnitt (3) auf der oberen Fläche und einem zweiten Abschnitt (4) auf zumindest einem Teil der Seitenflächen der ersten supraleitenden Schicht (1), so daß der zweite Abschnitt (4) der nicht supraleitenden Schicht (3, 4) dünner ist als der erste Abschnitt und eine Tunnelbarriere bildet zumindest an dem einen Teil der Seitenflächen der ersten supraleitenden Schicht (1); und
eine zweite supraleitende Schicht (2) aus dem Oxidsupraleitermaterial, welche gebildet ist auf den ersten und zweiten Abschnitten der nicht-supraleitenden Schicht (3, 4) und auf der Oberfläche des Substrates;
**dadurch gekennzeichnet, daß**
die nicht-supraleitende Schicht (3, 4) auch gebildet ist von einem dritten Abschnitt auf einem Teil der Oberfläche des Substrates (10), der angrenzt an den zumindest einen Teil der Seitenflächen der ersten supraleitenden Schicht (1) und sich in eine erste Richtung entlang der Oberfläche des Substrates erstreckt, wobei die Dicke des zweiten Abschnitts der nicht-supraleitenden Schicht geringer ist als eine Länge des dritten Abschnitts, der sich in die erste Richtung erstreckt, und die ersten, zweiten und dritten Abschnitte der nicht-supraleitenden Schicht alle aus dem nicht-supraleitenden Material sind; und daß
die zweite supraleitende Schicht (2) auch auf dem dritten Abschnitt der nicht-supraleitenden Schicht gebildet ist.

2. Supraleiter-Übergangsstruktur nach Anspruch 1, wobei die erste supraleitende Schicht (1) in Streifenform gebildet ist, und die zweite supraleitende Schicht (2) in Streifenform gebildet ist, welche im wesentlichen eine T-Form bezüglich der ersten supraleitenden Schicht (1) bildet.

3. Supraleiter-Übergangsstruktur nach Anspruch 1, wobei die ersten und zweiten supraleitenden Schichten (1, 2) aus einem Kristall gebildet sind, dessen c-kristallografische Achse senkrecht zur Oberfläche des Substrates (10) orientiert ist.

4. Supraleiter-Übergangsstruktur nach Anspruch 1, wobei das Substrat (10) aus einem Metalloxid besteht.

5. Supraleiter-Übergangsstruktur nach Anspruch 1, wobei die ersten und zweiten leitfähigen Schichten (1, 2) gebildet sind aus einem Material der Gruppe Cu-O, einem Material der Gruppe Bi-Sr-Ca-Cu-O, oder einem Material der Gruppe Tl-Ba-Ca-Cu-O.

6. Supraleiterübergangsstruktur nach Anspruch 1, wobei die nicht-supraleitende Schicht (3) aus einem Metall, einem Halbleiter oder einem Isolator besteht.

7. Verfahren zur Herstellung einer Supraleiter-Übergangsstruktur, umfassend:
Abscheiden einer ersten supraleitenden Schicht (1) eines Oxidsupraleitermaterials in einem gewünschten Muster auf einem Substrat (10), so daß die erste supraleitende Schicht (1) eine obere Fläche und eine Vielzahl von Seitenflächen hat;
Abscheiden einer nicht-supraleitenden Schicht (3, 4) aus einem nicht-supraleitenden Material in einem ersten Abschnitt (3) auf der oberen Fläche und in einem zweiten Abschnitt (4) auf zumindest einem Teil der Seitenflächen der ersten supraleitenden Schicht (1), so daß der zweite Abschnitt (4) der nicht-supraleitenden Schicht dünner ist als der erste Abschnitt, und eine Tunnelbarriere an zumindest dem Teil der Seitenflächen der ersten supraleitfähigen Schicht (1) bildet; und
Abscheiden einer zweiten supraleitenden Schicht (2) aus dem Oxidsupraleitermaterial auf den ersten und zweiten Abschnitten der nicht-supraleitenden Schicht (3, 4) und auf der Oberfläche des Substrates,
**gekennzeichnet durch:**
Abscheiden der nicht-supraleitenden Schicht (3, 4) in einem dritten Abschnitt auf einem Teil der Oberfläche des Substrates (10), welcher angrenzt an den Teil der Seitenflächen der ersten supraleitenden Schicht (1) und sich in eine erste Richtung entlang der Oberfläche des Substrates erstreckt, so daß die Dicke des zweiten Abschnitts der nicht-supraleitenden Schicht geringer ist als die Länge des dritten Abschnitts, welcher sich in die erste Richtung erstreckt, wobei die ersten, zweiten und dritten Abschnitte der nicht-supraleitenden Schicht alle aus dem Nicht-Supraleitermaterial sind; und
Abscheiden der zweiten supraleitenden Schicht (2) auf dem dritten Abschnitt der nicht-supraleitenden Schicht.

8. Verfahren zur Herstellung einer Supraleiter-Übergangsstruktur nach Anspruch 7, wobei die erste supraleitende Schicht (1) aus dem Oxidsupraleitermaterial abgeschieden wird mit einer Maske mit einer Öffnung, die dem gewünschten Muster entspricht und über dem Substrat (10) positioniert wird.

9. Verfahren zur Herstellung einer Supraleiter-Übergangsstruktur nach Anspruch 7, wobei die ersten und zweiten supraleitenden Schichten (1, 2) und die nichtsupraleitende Schicht (3) durch Sputtern, epitaktisches Wachstum, Vakuumverdampfung oder Laserabtragung gebildet werden.

## Revendications

1. Structure de jonction supraconductrice comprenant :
une première couche supraconductrice (1) d'un matériau supraconducteur à oxyde formé selon une configuration souhaitée sur un substrat (10) de sorte que la première couche supraconductrice (1) ait une surface supérieure et une pluralité de surfaces latérales ;
une couche non-supraconductrice (3, 4) d'un matériau non-supraconducteur constituée d'une première partie (3) sur la surface supérieure et d'une seconde partie (4) sur au moins une partie des surfaces latérales de la première couche supraconductrice (1), de sorte que la seconde partie (4) de la couche non-supraconductrice (3, 4) soit plus mince que la première partie et forme une barrière tunnel au niveau de ladite au moins une partie des surfaces latérales de la première couche supraconductrice (1) ; et
une seconde couche supraconductrice (2) dudit matériau supraconducteur à oxyde formée sur les première et seconde parties de la couche non-supraconductrice (3, 4) et sur la surface du substrat ;
caractérisée en ce que :
la couche non-supraconductrice (3, 4) est également constituée d'une troisième partie sur une partie de la surface du substrat (10) contigue à ladite au moins une partie des surfaces latérales de la première couche supraconductrice (1) et s'étendant dans une première direction le long de la surface du substrat, l'épaisseur de la seconde partie de la couche non-supraconductrice étant inférieure à une longueur de ladite troisième partie s'étendant dans ladite première direction, lesdites première, seconde et troisième parties de ladite couche non-supraconductrice étant toutes dudit matériau non-supraconducteur ; et en ce que
la seconde couche supraconductrice (2) est également formée sur ladite troisième partie de la couche non-supraconductrice.

2. Structure de jonction supraconductrice selon la revendication 1, dans laquelle la première couche supraconductrice (1) est en forme de bande, et la seconde couche supraconductrice (2) est en forme de bande formant sensiblement une forme en T par rapport à la première couche supraconductrice (1).

3. Structure de jonction supraconductrice selon la revendication 1, dans laquelle les première et seconde couches supraconductrices (1, 2) sont constituées d'un cristal avec l'axe cristallographique c orienté perpendiculaire à la surface du substrat (10).

4. Structure de jonction supraconductrice selon la revendication 1, dans laquelle le substrat (10) est constitué d'un oxyde métallique.

5. Structure de jonction supraconductrice selon la revendication 1, dans laquelle les première et seconde couches conductrices (1, 2) sont constituées d'un matériau du groupe Cu-O, d'un matériau du groupe Bi-Sr-Ca-Cu-O, ou d'un matériau du groupe Ti-Ba-Ca-Cu-O.

6. Structure de jonction supraconductrice selon la revendication 1, dans laquelle la couche non-supraconductrice (3) est constituée d'un métal, d'un semi-conducteur ou d'un isolant.

7. Procédé de fabrication d'une structure de jonction supraconductrice comprenant :
le dépôt d'une première couche supraconductrice (1) d'un matériau supraconducteur à oxyde selon une configuration souhaitée sur un substrat (10), de sorte que la première couche supraconductrice (1) ait une surface supérieure et une pluralité de surfaces latérales ;
le dépôt d'une couche non-supraconductrice (3, 4) d'un matériau non-supraconducteur dans une première partie (3) sur la surface supérieure et dans une seconde partie (4) sur au moins une partie des surfaces latérales de la première couche supraconductrice (1), de sorte que la seconde partie (4) de la couche non-supraconductrice soit plus mince que la première partie et forme une barrière tunnel au niveau de ladite au moins une partie des surfaces latérales de la première couche supraconductrice (1) ; et
le dépôt d'une seconde couche supraconductrice (2) dudit matériau supraconducteur à oxyde sur les première et seconde parties de la couche non-supraconductrice (3, 4) et sur la surface du substrat ;
caractérisé par :
le dépôt de la couche non-supraconductrice (3, 4) dans une troisième partie sur une partie de la surface du substrat (10) contiguë à ladite au moins une partie des surfaces latérales de la première couche supraconductrice (1) et s'étendant dans une première direction le long de la surface du substrat, de sorte que l'épaisseur de la seconde partie de la couche non-supraconductrice soit inférieure à la longueur de ladite troisième partie s'étendant dans ladite première direction, lesdites première, seconde, et troisième parties de ladite couche non-supraconductrice étant toutes dudit matériau non-supraconducteur ; et
le dépôt de ladite seconde couche supraconductrice (2) sur ladite troisième partie de la couche non-supraconductrice.

8. Procédé de fabrication d'une structure de jonction supraconductrice selon la revendication 7, dans lequel la première couche supraconductrice (1) dudit matériau supraconducteur à oxyde est déposée avec un masque comportant une ouverture correspondant à ladite configuration souhaitée positionné au-dessus du substrat (10).

9. Procédé de fabrication d'une structure de jonction supraconductrice selon la revendication 7, dans lequel les première et seconde couches supraconductrices (1, 2) et la couche non-supraconductrice (3) sont formées par pulvérisation cathodique, par épitaxie, par évaporation sous vide ou par ablation par rayon laser.
